# FASCICULE DE BREVET EUROPEEN

(11) **EP 3 758 171 B1**
(45) Date de publication et mention de la délivrance du brevet: **02.10.2024**
(21) Numéro de dépôt: 20181552.9
(22) Date de dépôt: 23.06.2020
(51) Int. Cl.: H02B 1/01, H02B 1/30

(54) **DISPOSITIF D'ASSEMBLAGE ET ARMATURE D'ARMOIRE ÉLECTRIQUE COMPRENANT UN TEL DISPOSITIF**
MONTAGEVORRICHTUNG UND SCHALTSCHRANKGESTELL MIT EINER SOLCHEN VORRICHTUNG
ASSEMBLING DEVICE AND ELECTRIC CABINET FRAME COMPRISING SUCH A DEVICE

(30) Priorité: 24.06.2019 FR 1906793
(43) Date de publication de la demande: 30.12.2020
(73) Titulaire: Schneider Electric Industries SAS, 92500 Rueil Malmaison (FR)
(72) Inventeur: DESCHANG, Fabien, 38050 GRENOBLE Cedex 09 (FR)
(74) Mandataire: Lavoix

(56) Documents cités:
- EP-A1- 0 902 515
- WO-A1-2008/067837
- CN-U- 202 617 567
- US-B1- 6 179 398

## Description

La présente invention concerne un dispositif d'assemblage pour un cadre d'une armature d'armoire électrique, ainsi qu'une armature d'armoire électrique comprenant un tel dispositif d'assemblage.

Les armoires électriques destinées à accueillir divers appareils électriques, tels que des alimentations, des automates, des disjoncteurs, etc., sont généralement constituées d'une armature rigide de forme parallélépipédique à laquelle sont fixés les divers appareils électriques précités, ou bien des étagères supportant ces appareils. L'armature est constituée de rails et de montants formés par des profilés métalliques assemblés par des raccords d'angle, ces derniers étant placés au niveau des huit coins du parallélépipède. Des panneaux de protection ou des portes peuvent aussi être fixés à cette armature pour former des parois de l'armoire électrique. Pour des raisons pratiques, une telle armature est généralement partiellement assemblée en usine, le montage étant ensuite finalisé sur site. Par exemple, des rails, coupés aux dimensions voulues, sont assemblés en usine à quatre raccords d'angle pour constituer deux cadres de forme rectangulaire, et ces deux cadres sont ensuite assemblés sur site à quatre montants de longueurs identiques, cet assemblage se faisant au niveau des raccords d'angle.

Le document WO 2008/067837 A1 divulgue des connecteurs d'angle permettant l'assemblage d'une armoire dont l'armature est constituée de rails. Ces connecteurs présentent des protrusions permettant de positionner les rails avant application d'un cordon de soudure permettant de fixer les rails sur les connecteurs. Les connecteurs présentent également des protrusions secondaires. Les rails sont équipés de bandes d'étanchéité. Les bandes d'étanchéité sont prévues pour permettre la fixation d'un joint d'étanchéité, non-représenté dans ce document. Ce joint d'étanchéité a pour fonction d'assurer une fermeture étanche d'une porte non-représentée sur une ouverture de l'armature, l'ouverture représentant une face de l'armature formée par les rails. Pour assurer cette étanchéité, le joint d'étanchéité doit parcourir l'ensemble de la circonférence de cette ouverture de manière continue. Or, les bandes d'étanchéité ne peuvent pas supporter le joint dans les angles de l'armature, car elles ne s'étendent pas au-delà des rails desquels elles font intégralement partie. Pour permettre la fixation du joint dans les angles, ce document divulgue donc les protrusions secondaires précités, appartenant aux connecteurs, ces protrusions secondaires assurant une continuité avec les bandes d'étanchéité.

De son côté, US 6 179 398 B1 divulgue des connecteurs d'angle permettant l'assemblage d'une armoire dont l'armature est constituée de rails. Ces connecteurs présentent des protrusions permettant la mise en place de profilés. Après mise en place, les profilés sont soudés par un cordon de soudure appliqué sur une zone dédiée appartenant au connecteur et les profilés sont rendus solidaires des profilés à l'aide d'un assemblage boulonné. Ces connecteurs présentent également d'autres protrusions permettant d'y fixer un joint d'étanchéité.

Les raccords d'angles connus sont des pièces complexes dont la fabrication est également complexe et coûte cher. Ces raccords d'angle comportent des pièces supplémentaires de rigidification qui doivent être soudées aux profilés à travers des ouvertures pratiquées dans les profilés, ce qui occasionne de multiples étapes d'assemblage. Ces raccords d'angles aux multiples pièces nécessitent également la fabrication de joints aux formes complexes. Ces types de raccords d'angles occasionnent donc des coûts de fabrication importants et n'offrent en outre pas une rigidité optimale.

C'est à ces inconvénients qu'entend remédier l'invention en proposant un nouveau dispositif d'assemblage, comportant moins de pièces que les dispositifs connus, et également plus simple d'utilisation et procurant une meilleure rigidité.

A cet effet, l'invention concerne une armature d'armoire électrique, telle que définie à la revendication 1.

Grâce à l'invention, la liaison entre les profilés et les raccords d'angle se fait par complémentarité de formes entre les cavités internes des profilés, qui sont présentes du fait de la fabrication initiale de ceux-ci, et des protubérances d'une pièce de raccord du raccord d'angle, la solidarisation étant fournie par un cordon de soudure. Il en résulte un assemblage simple et rigide, comportant un nombre de pièces réduit au minimum. Des doigts de fixation permettent avantageusement de fixer un bandeau.

Des aspects avantageux mais non obligatoires de l'invention sont spécifiés aux revendications 2 à 9.

L'invention sera mieux comprise et d'autres avantages de celle-ci apparaîtront plus clairement à la lumière de la description qui va suivre d'un dispositif d'assemblage et d'une armature d'armoire électrique conformes à son principe, faite à titre d'exemple non limitatif en référence aux dessins annexés, dans lesquels :
[Fig 1] la figure 1 est une vue en perspective d'une armature d'armoire électrique conforme à l'invention ;
[Fig 2] la figure 2 est une vue en perspective d'un dispositif d'assemblage de l'armature de la figure 1 ;
[Fig 3] la figure 3 est une vue éclatée de la perspective de la figure 2 ;
[Fig 4] la figure 4 est une vue en perspective, selon un côté opposé, du dispositif de la figure 2.
[Fig 5] la figure 5 est une coupe selon le plan V-V du dispositif de la figure 2.
[Fig 6] la figure 6 est une vue en perspective d'un coin de l'armature de la figure 1 montrant un bandeau fixé sur le coin ;
[Fig 7] la figure 7 est une vue de côté montant la fixation du bandeau de la figure 6 sur un coin de l'armature.

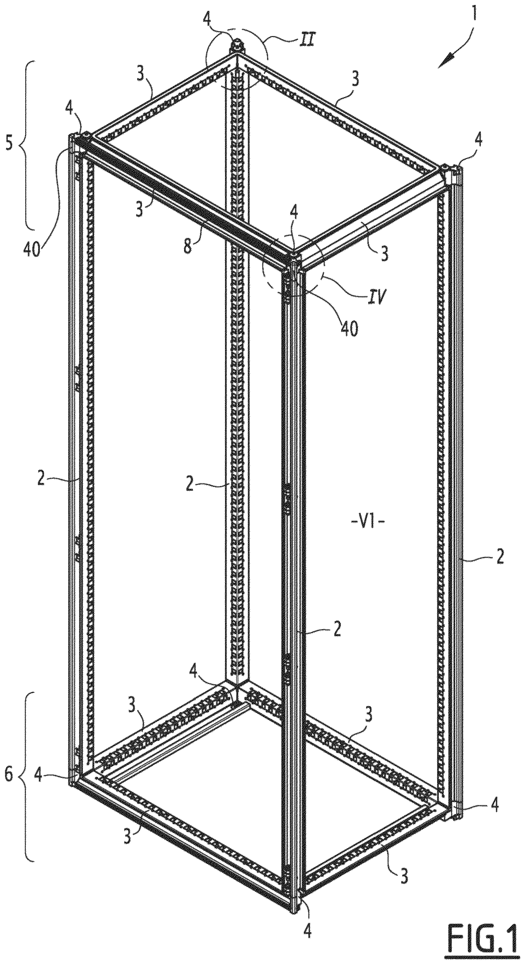

La figure 1 représente une armature 1, utilisée par exemple comme structure porteuse d'une armoire électrique.

L'armature 1 est représentée posée sur une surface horizontale. L'armature 1 présente une forme parallélépipédique, et définit un volume interne V1.

L'armature 1 comprend quatre montants 2 disposés verticalement, par exemple de façon à former les arêtes latérales dudit parallélépipède. Les montants 2 relient un cadre haut 5 à un cadre bas 6. Les cadres 5 et 6 comprennent chacun quatre rails 3, disposés sur les arêtes des faces supérieure et inférieure du parallélépipède, et quatre raccords d'angle 4, un raccord d'angle 4 étant situé à chacun des coins des cadres 5 et 6.

Avantageusement, tous les raccords d'angle 4 présentent ici la même forme, ce qui simplifie la fabrication et la gestion des stocks de pièces détachées. En variante non représentée, les raccords d'angle 4 peuvent présenter des formes différentes.

Par commodité, un seul raccord d'angle 4 est décrit dans la suite.

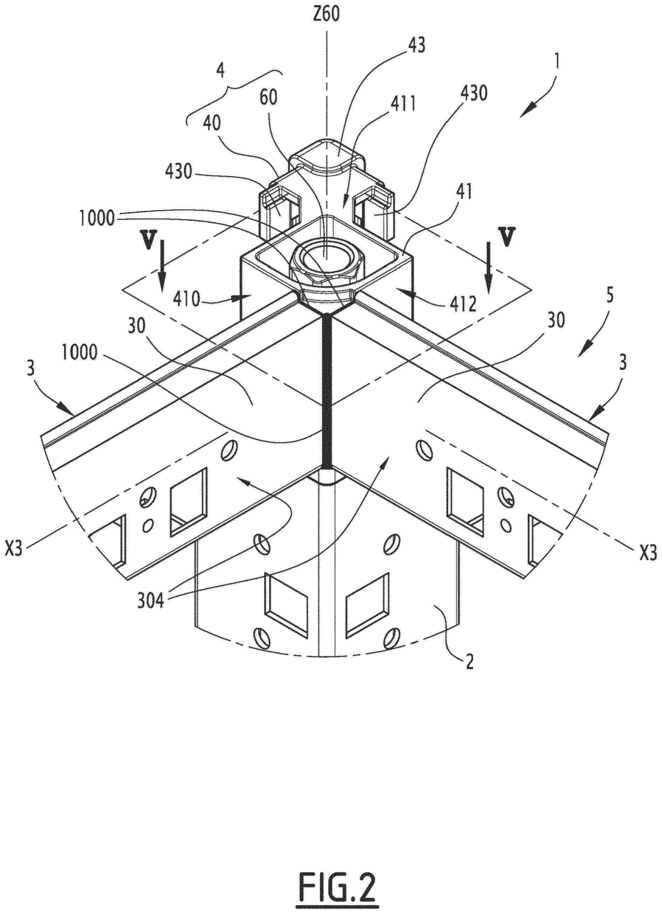

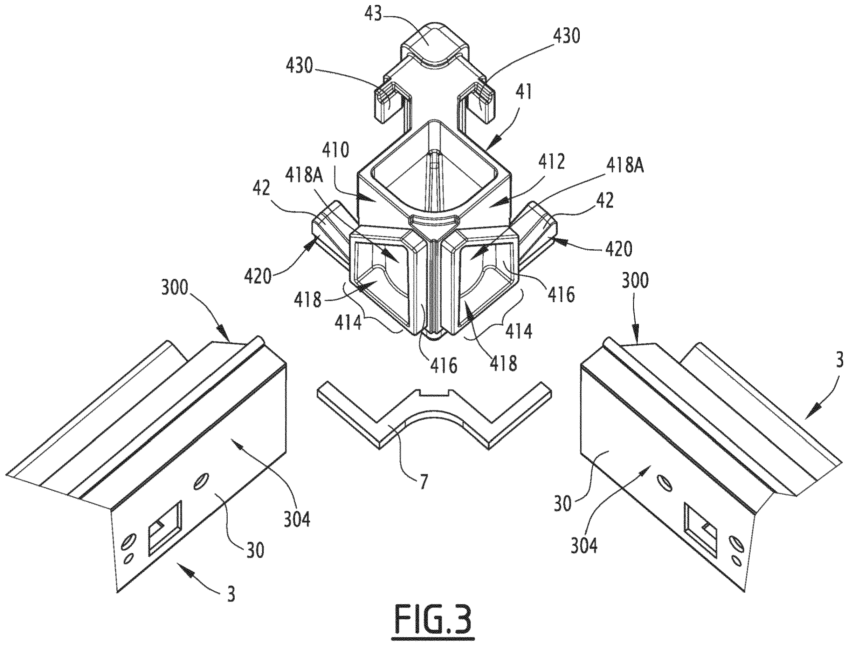

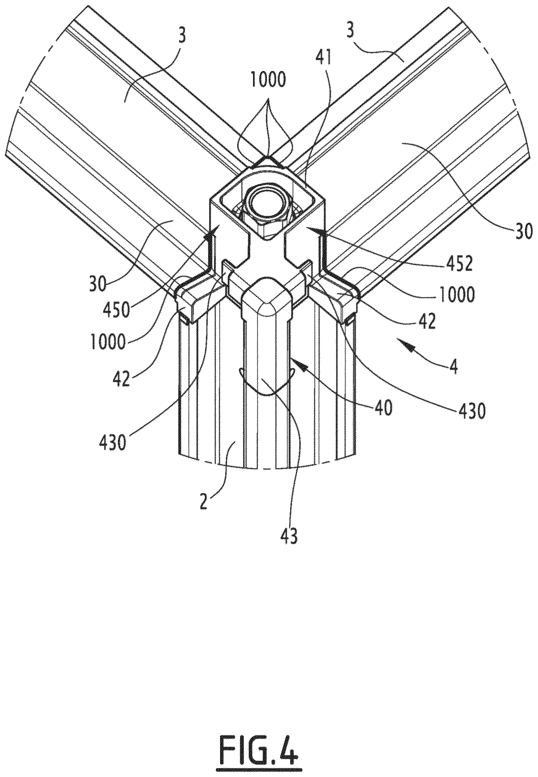

Un seul raccord d'angle 4 est représenté en perspective sur les figures 2 et 4, et en perspective éclatée sur la figure 3.

De façon analogue, les quatre montants 2 présentent chacun une structure identique, tandis que les rails 3 des cadres haut 5 et bas 6 sont identiques les uns aux autres.

Les rails 3 et les montants 2 sont réalisés en métal, de préférence en acier galvanisé, cet exemple n'étant pas limitatif.

Selon un aspect non représenté, des parois peuvent être montées sur l'armature 1 pour couvrir les faces de l'armature 1 et fermer au moins partiellement le volume V1. Par exemple, les parois peuvent être des portes ou des panneaux.

Chaque raccord d'angle 4 comprend une pièce de raccord 40 et une vis 60 assurant la fixation du raccord d'angle 4 au montant 2, et qui définit un axe vertical Z60. Dans cette description, la pièce de raccord 40 décrite appartient au cadre supérieur 5. Les notions de « haut » et de « bas » sont donc, dans ce qui suit pour la description de cette pièce de raccord 40, définis en référence à cette position de la pièce de raccord 40. Dans certains exemples, le cadre inférieur 6 est inversé symétriquement par rapport au cadre supérieur 5. L'orientation de la pièce de raccord 40 du cadre 6 est alors adaptée en conséquence.

La pièce de raccord 40 est réalisée en métal, de préférence en acier, et est obtenue par moulage, notamment par moulage à cire perdue, ces exemples de matériaux et de mode de fabrication n'étant pas limitatifs.

La pièce de raccord 40 comprend un corps principal 41. Le corps principal 41 présente une forme cylindrique de génératrice verticale et de section polygonale, de préférence une section quadrilatère, notamment une section rectangulaire. Le corps principal 41 présente deux faces latérales avant 410 et 412, qui sont orientées vers les rails 3, ainsi que deux faces latérales arrière 450 et 452, orientées à l'opposé des rails 3. Sur la figure 2, les faces latérales arrières 450 et 452 sont masquées. Sur la figure 4, les faces latérales avant 410 et 412 sont masquées. Les deux faces latérales avant 410 et 412 sont situées dans des plans verticaux et orthogonaux entre eux.

La pièce de raccord 40 comprend aussi deux excroissances 42. Les deux excroissances 42 s'étendent horizontalement en saillie des faces latérales arrière 450 et 452 en s'éloignant du volume interne V1. Par exemple, les deux excroissances 42 sont en forme de trapèze et présentent chacune une face latérale 420 située dans le prolongement d'une des faces latérales avant 410 et 412.

Les rails 3 présentent chacun une extrémité 30 présentant un bord d'extrémité 300 qui coopère avec la première surface latérale avant 410 et la deuxième surface latérale avant 412 du corps principal 41, et les faces latérales 420 des excroissances 42.

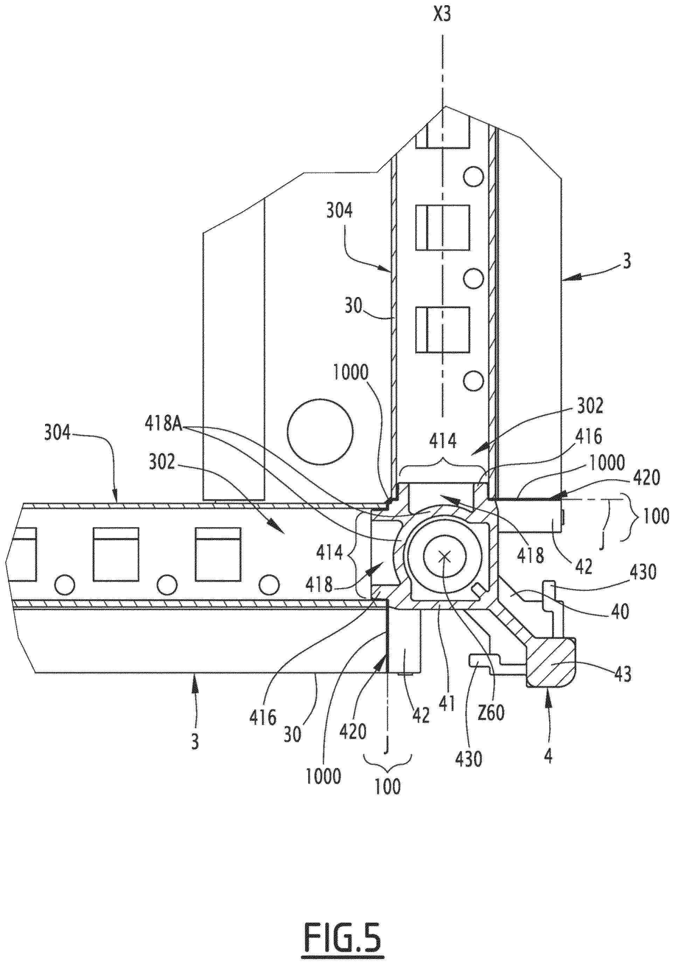

Les rails 3 et les raccords d'angle 4 sont assemblés au moyen de dispositifs d'assemblage 100, représentés sur les figures 2 à 5.

L'armature 1 comprend également un joint 7 inséré entre chaque raccord d'angle 4 et chaque montant 2.

Chaque dispositif d'assemblage 100 comporte une cavité interne 302 formée sur chaque rail 3, et une protubérance 414 formée sur la pièce de raccord 40, et adaptée pour être reçue dans la cavité interne 302. Le dispositif d'assemblage 100 comprend également un cordon de soudure 1000 appliqué le long d'une jointure J entre le bord d'extrémité 300 du rail 3 et la face latérale avant 410 ou 412 qui forme une face d'extrémité de la pièce de raccord 40 sur laquelle est prévue la protubérance 414.

La cavité interne 302 est de préférence une cavité formée lors de la fabrication du profilé constituant le rail 3. Ainsi la cavité interne 302 peut s'étendre sur toute la longueur du rail 3. En variante non représentée, la cavité interne 302 peut ne se trouver qu'à l'extrémité 30, ou bien être une cavité distincte d'une cavité principale du profilé. La cavité interne 302 est entourée par le bord d'extrémité 300.

La protubérance 414 de la pièce de raccord 40 est formée par une nervure 416 en saillie de la face latérale avant 410 ou 412. Les dimensions extérieures de la nervure 416 sont égales ou légèrement inférieures aux dimensions internes de la cavité interne 302. La nervure 416 définit un contour fermé entourant un espace creux 418, dont un fond 418A présente une forme courbe dont le centre de courbure est situé sur l'axe vertical Z60. En variante non représentée, la protubérance 414 pourrait également être formée par un bloc de matière plein.

Le cordon de soudure 1000 solidarise directement la nervure 416 à l'extrémité 30 du rail 3. Il en résulte une grande simplicité de montage et de fixation et une bonne rigidité.

Sur un côté intérieur du cadre 5 ou 6, c'est-à-dire le long d'une jointure entre la pièce de raccord 40 et des faces verticales 304 des rails 3 orientée vers le côté interne de l'armature 1, le cordon de soudure 1000 a une forme prismatique continue visible sur les figures 2, 4 et 5. Cette forme prismatique relie à la fois la pièce de raccord 40 à un premier rail 3, à un deuxième rail 3, mais également les deux rails 3 l'un à l'autre.

Une partie du bord d'extrémité 300 du rail 3 n'enveloppe pas la protubérance 414 de la pièce d'angle 40, et est en appui contre une partie de la face d'extrémité 410 de la pièce d'angle 40 sur laquelle ne s'étend pas la protubérance 414, c'est-à-dire la face 420 des excroissances 42. Sur cette partie, l'extrémité 30 du rail 3 est directement soudée à la face 420.

Le cordon de soudure 1000 s'étend de façon continue sur toute la circonférence du bord d'extrémité 300. Ce cordon de soudure continu est simple à réaliser en ce que les surfaces à souder sont accessibles facilement par l'extérieur des rails 3.

Selon un aspect optionnel, les formes complémentaires de la cavité interne 302 et de la protubérance 414 assurent une immobilité en rotation du rail 3 par rapport à la pièce de raccord 40 autour d'un axe longitudinal X3 du rail 3. Par exemple, les formes complémentaires de la cavité interne 302 et de la protubérance 414 peuvent être polygonales, notamment de forme trapézoïdale. Cette forme non circulaire permet d'assurer un blocage en rotation. Toute autre forme non circulaire pourrait être envisagée.

Selon un aspect optionnel, les formes complémentaires de la cavité interne 302 et de la protubérance 414 peuvent définir un profil non symétrique, permettant de repérer le positionnement correct du rail 3 par rapport à la pièce d'angle 40.

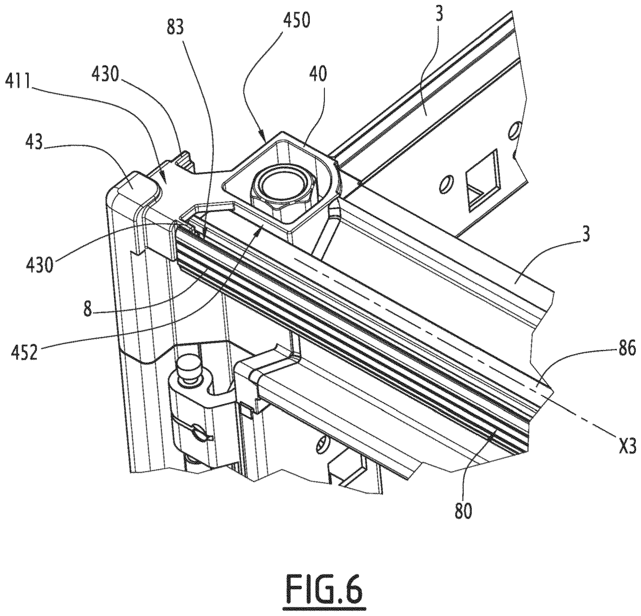

Selon un aspect représenté aux figures 1, 6 et 7, l'armature 1 comprend au moins un bandeau 8 parallèle à un rail 3 fixé sur des doigts 430 prévus sur les pièces de raccord 40.

Chaque pièce de raccord 40 comporte une excroissance 43 s'étendant à partir du corps principal 41, et à partir de cette excroissance 43, les doigts 430 de fixation du bandeau 8, ces doigts de fixation 430 d'étendant parallèlement aux axes longitudinaux X3 et parallèlement aux rails 3. Les doigts 430 sont prévus d'un côté supérieur de la pièce de raccord 40, repéré par une face supérieure 411. Deux pièces de raccord 40 de deux raccords d'angles 4 reliant un même rail 3 comprennent chacune un doigt 430 de fixation, ces deux doigts 430 se faisant face, et supportant un bandeau 8, fixé à chacune de ses extrémités longitudinales à l'un des deux doigts 430. Le bandeau 8 se trouve légèrement en avant du rail 3 qu'il longe.

De préférence, le bandeau 8 est en matériau synthétique, par exemple en matière plastique extrudée. Il peut présenter, sur une face externe 80, des rainures ornementales. Il peut également être en matériau translucide ou transparent et incorporer des dispositifs électroniques, par exemple des éclairages tels que des LED, ou des affichages de paramètres de fonctionnement de l'armoire électrique, par exemple température, données électriques, etc.

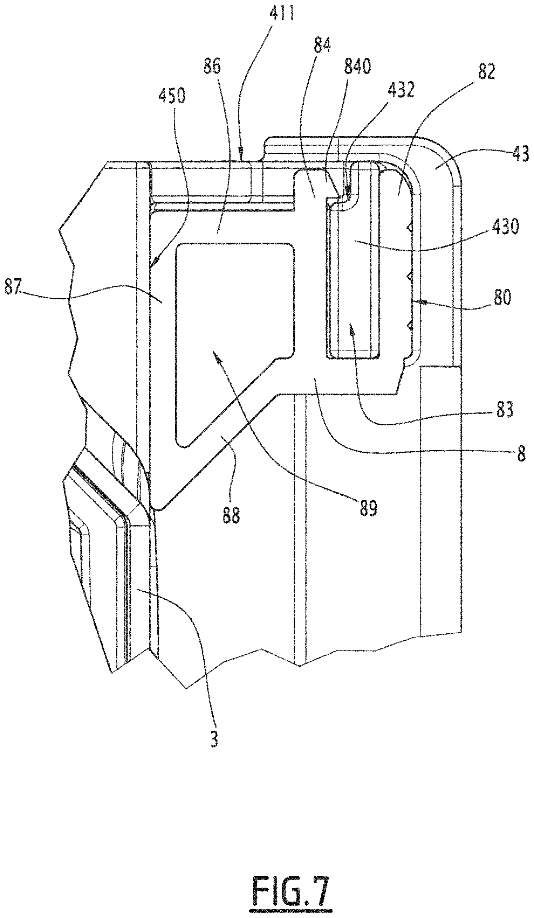

En vue transversale représentée à la figure 7, le bandeau 8 comporte une paroi arrière verticale 87 s'appuyant contre la surface 450 de la pièce de raccord 40 sur laquelle il est monté (ou la surface 452, suivant le côté de la pièce de raccord 40 sur lequel le bandeau 8 est fixé). Le bandeau 8 comporte une paroi centrale verticale 84 et une paroi avant verticale 82 qui porte la face avant 80. Les parois centrale 84 et avant 82 sont éloignées l'une de l'autre et forment une rainure interne longitudinale 83 qui est clipsée, à chacune des extrémités du bandeau 8 sur l'un des doigts de fixation 430. La rainure 83 accueille le doigt 430 et le retient au moyen d'un rebord d'accroche 840 prévu sur la paroi centrale 84, et qui ferme le haut de la rainure 83 pour empêcher le détachement du bandeau 8. Le rebord d'accroche 840 est accueilli dans un épaulement 432 du doigt 430. La paroi arrière 87 est reliée à la paroi centrale 84 par une paroi horizontale haute 86, et par une paroi oblique 88. Les parois 84, 86, 87 et 88 forment une cavité 89.

Le bandeau 8 est représenté fixé entre deux pièces de raccord 40 du cadre supérieur 5. En variante, le bandeau 8 peut être fixé à d'autres emplacements de l'armature 1, par exemple sur le cadre inférieur 6, ou entre d'autres raccords d'angles 4 que ceux représentés à la figure 1. L'armature 1 peut également comprendre plusieurs bandeaux 8 fixés à différents emplacements.

## Revendications

1. Armature (1) d'armoire électrique, comprenant un cadre supérieur (5) et un cadre inférieur (6) reliés par des montants (2), chacun des cadres supérieur (5) et cadre inférieur (6) comprenant quatre rails (3) reliés par des raccords d'angles (4), les raccords d'angle (4) étant reliés aux montants (2), l'armature d'armoire électrique comprenant des dispositifs d'assemblage (100) au moyen de chacun desquels un des rails (3) et un des raccords d'angle (4) sont assemblés,
dans laquelle chaque dispositif d'assemblage (100) comporte une cavité interne (302) formée à une extrémité (30) du rail (3), une protubérance (414) formée sur une pièce de raccord (40) du raccord d'angle (4), et adaptée pour être reçue dans la cavité interne (302) du rail (3), la protubérance (414) et la cavité interne (302) étant de formes complémentaires,
dans laquelle chaque dispositif d'assemblage (100) comprend également un cordon de soudure (1000) appliqué le long d'une jointure (J) entre un bord d'extrémité (300) du rail (3), entourant la cavité interne (302), et une face d'extrémité (410, 412) de la pièce de raccord (40) sur laquelle est prévue la protubérance (414),
**caractérisée en ce que** dans l'armature d'armoire électrique la pièce de raccord (40) comporte des doigts (430) de fixation d'un bandeau (8), ces doigts de fixation (430) s'étendant selon des directions (X3) parallèles aux rails (3).

2. Armature (1) d'armoire électrique selon la revendication 1, dans laquelle la protubérance (414) de la pièce de raccord (40) est formée par une nervure (416) en saillie de la face d'extrémité (410, 412).

3. Armature (1) d'armoire électrique selon la revendication 2, dans laquelle une partie du bord d'extrémité (300) du rail (3) n'enveloppe pas la protubérance (414) de la pièce d'angle (40) et est en appui contre une partie de la face d'extrémité (410, 412) de la pièce d'angle (40) sur laquelle ne s'étend pas la protubérance (414).

4. Armature (1) d'armoire électrique selon la revendication 2, dans laquelle les formes complémentaires de la cavité interne (302) et de la protubérance (414) assurent une immobilité en rotation du rail (3) par rapport à la pièce d'angle (40) selon un axe longitudinal (X3) du rail (3).

5. Armature (1) d'armoire électrique selon la revendication 2, dans laquelle les formes complémentaires de la cavité interne (302) et de la protubérance (414) sont polygonales.

6. Armature d'armoire électrique selon l'une des revendications 1 à 5, dans laquelle l'armature (1) comprend au moins un bandeau (8) fixé sur les doigts (430) de deux pièces de raccord (40) de deux raccords d'angles (4) reliant un même rail (3), le bandeau étant parallèle à ce rail (3).

7. Armature d'armoire électrique selon la revendication 6, dans laquelle le bandeau (8) est en matériau synthétique.

8. Armature d'armoire électrique selon l'une des revendications 6 et 7, dans laquelle le bandeau (8) est en matériau translucide ou transparent et incorpore des dispositifs électroniques, par exemple des éclairages tels que des LED ou des affichages de paramètres de fonctionnement de l'armoire électrique.

9. Armature d'armoire électrique selon l'une des revendications 6 à 8, dans laquelle le bandeau (8) comporte une paroi arrière (87) s'appuyant contre une surface (450, 452) de la pièce de raccord (40), et une rainure interne longitudinale (83) clipsée à chacune des extrémités de ce bandeau (8) sur l'un des doigts de fixation (430).

## Patentansprüche

1. Gestell (1) für Schaltschrank, umfassend einen oberen Rahmen (5) und einen unteren Rahmen (6), die durch Ständer (2) verbunden sind, wobei jeder von dem oberen Rahmen (5) und dem unteren Rahmen (6) vier Schienen (3) umfasst, die durch Eckverbinder (4) verbunden sind, wobei die Eckverbinder (4) mit den Ständern (2) verbunden sind, wobei das Schaltschrankgestell Montagevorrichtungen (100) umfasst, mittels derer jeweils eine der Schienen (3) und einer der Eckverbinder (4) montiert werden,
wobei jede Montagevorrichtung (100) einen inneren Hohlraum (302), der an einem Ende (30) der Schiene (3) gebildet ist, einen Vorsprung (414), der an einem Verbindungsstück (40) des Eckverbinders (4) gebildet ist und angepasst ist, um in dem inneren Hohlraum (302) der Schiene (3) aufgenommen zu werden, umfasst, wobei der Vorsprung (414) und der innere Hohlraum (302) von komplementärer Form sind,
wobei jede Montagevorrichtung (100) auch eine Schweißnaht (1000) umfasst, die entlang einer Fuge (J) zwischen einer Endkante (300) der Schiene (3), die den inneren Hohlraum (302) umgibt, und einer Endfläche (410, 412) des Verbindungsstücks (40), an der der Vorsprung (414) bereitgestellt ist, aufgebracht wird,
**dadurch gekennzeichnet, dass** das Verbindungsstück (40) in dem Schaltschrankgestell Finger (430) zum Befestigen einer Blende (8) umfasst, wobei sich diese Befestigungsfinger (430) in Richtungen (X3) parallel zu den Schienen (3) erstrecken.

2. Gestell (1) für Schaltschrank nach Anspruch 1, wobei der Vorsprung (414) des Verbindungsstücks (40) durch eine Rippe (416) gebildet ist, die von der Endfläche (410, 412) hervorsteht.

3. Gestell (1) für Schaltschrank nach Anspruch 2, wobei ein Teil der Endkante (300) der Schiene (3) den Vorsprung (414) des Eckstücks (40) nicht umschließt und an einem Teil der Endfläche (410, 412) des Eckstücks (40) anliegt, auf dem sich der Vorsprung (414) nicht erstreckt.

4. Gestell (1) für Schaltschrank nach Anspruch 2, wobei die komplementären Formen des inneren Hohlraums (302) und des Vorsprungs (414) eine Drehsperre der Schiene (3) in Bezug auf das Eckstück (40) entlang einer Längsachse (X3) der Schiene (3) gewährleisten.

5. Gestell (1) für Schaltschrank nach Anspruch 2, wobei die komplementären Formen des inneren Hohlraums (302) und des Vorsprungs (414) polygonal sind.

6. Gestell für Schaltschrank nach einem der Ansprüche 1 bis 5, wobei das Gestell (1) mindestens eine Blende (8) umfasst, die an den Fingern (430) von zwei Verbindungsstücken (40) von zwei Eckverbindern (4) befestigt ist, die ein und dieselbe Schiene (3) verbinden, wobei die Blende parallel zu dieser Schiene (3) ist.

7. Gestell für Schaltschrank nach Anspruch 6, wobei die Blende (8) aus einem synthetischen Material ist.

8. Gestell für Schaltschrank nach einem der Ansprüche 6 oder 7, wobei die Blende (8) aus einem lichtdurchlässigen oder transparenten Material ist und elektronische Vorrichtungen, zum Beispiel Beleuchtungen, wie beispielsweise LEDs oder Anzeigen von Betriebsparametern des Schaltschranks, integriert.

9. Gestell für Schaltschrank nach einem der Ansprüche 6 bis 8, wobei die Blende (8) eine Rückwand (87), die an einer Oberfläche (450, 452) des Verbindungsstücks (40) anliegt, und eine innere Längsnut (83), die an jedem der Enden dieser Blende (8) an einem der Befestigungsfinger (430) eingeclipst ist, umfasst.

## Claims

1. An electrical cabinet frame (1), comprising an upper frame (5) and a lower frame (6) connected by uprights (2), each of the upper frame (5) and lower frame (6) comprising four rails (3) connected by corner connectors (4), the corner connectors (4) being connected to the uprights (2), the electrical cabinet frame comprising assembly devices (100) by means of each of which one of the rails (3) and one of the corner connectors (4) are assembled,
wherein each connector (100) comprises an internal cavity (302) formed at one end (30) of the rail (3), a protrusion (414) formed on a connector part (40) of the corner connector (4), and adapted to be received in the internal cavity (302) of the rail (3), the protuberance (414) and the internal cavity (302) being of complementary shapes,
in which each assembly device (100) also comprises a weld bead (1000) applied along a joint (J) between an end edge (300) of the rail (3), surrounding the internal cavity (302), and an end face (410, 412) of the connector (40) on which the protrusion (414) is provided,
**characterised in that**, in the electrical cabinet frame, the connection piece (40) comprises fingers (430) for fixing a strip (8), these fixing fingers (430) extending in directions (X3) parallel to the rails (3).

2. An electrical cabinet frame (1) as claimed in claim 1, in which the protrusion (414) of the connection piece (40) is formed by a rib (416) projecting from the end face (410, 412).

3. An electrical cabinet frame (1) according to claim 2, in which a part of the end edge (300) of the rail (3) does not surround the protuberance (414) of the corner piece (40) and bears against a part of the end face (410, 412) of the corner piece (40) over which the protuberance (414) does not extend.

4. An electrical cabinet frame (1) as claimed in claim 2, in which the complementary shapes of the internal cavity (302) and of the protuberance (414) ensure that the rail (3) is prevented from rotating relative to the corner piece (40) along a longitudinal axis (X3) of the rail (3).

5. An electrical cabinet frame (1) as claimed in claim 2, in which the complementary shapes of the internal cavity (302) and the protuberance (414) are polygonal.

6. An electrical cabinet frame according to one of claims 1 to 5, in which the frame (1) comprises at least one strip (8) fixed to the fingers (430) of two connecting pieces (40) of two corner connectors (4) connecting the same rail (3), the strip being parallel to this rail (3).

7. An electrical cabinet frame as claimed in claim 6, in which the fascia panel (8) is made of synthetic material.

8. An electrical cabinet frame according to one of claims 6 and 7, in which the fascia panel (8) is made of translucent or transparent material and incorporates electronic devices, for example lighting such as LEDs or displays of operating parameters of the electrical cabinet.

9. An electrical cabinet frame according to one of claims 6 to 8, in which the strip (8) comprises a rear wall (87) bearing against a surface (450, 452) of the connector part (40), and a longitudinal internal groove (83) clipped at each of the ends of this strip (8) onto one of the fixing fingers (430).
